# EUROPEAN PATENT SPECIFICATION

(11) **EP 1 538 635 B1**
(45) Date of publication and mention of the grant of the patent: **14.05.2008**
(21) Application number: 03292958.0
(22) Date of filing: 26.11.2003
(51) Int. Cl.: G11C 29/00

(54) **Scan testable first-in first-out architecture**
Scan-testbarer FIFO-Speicher
Mémoire fifo testable par balayage

(43) Date of publication of application: 08.06.2005
(73) Proprietor: Texas Instruments Incorporated, Dallas, TX 75265 (US); TEXAS INSTRUMENTS FRANCE, 06271 Villeneuve Loubet Cedex, Nice (FR)
(72) Inventor: Bombal, Jérome, 06600 Antibes (FR)
(74) Representative: Holt, Michael

(56) References cited:
- US-A- 6 061 813
- US-A1- 2002 138 797
- US-B1- 6 584 584

## Description

### BACKGROUND OF THE INVENTION

The present embodiments relate to electronic devices and circuits and are more particularly directed to such devices and circuits that include a scan testable first-in first-out ("FIFO") memory circuit.

Electronic circuits are prevalent in numerous applications, including those used in personal, business, and other devices. Demands of the marketplace affect many aspects of the design of these circuits, including factors such as device complexity, size, and cost. Various of these electronic circuits include some aspect of digital signal processing and, quite often, these circuits include storage devices that operate on a FIFO basis. As is well-known in the art, such FIFO circuits are so named because data words are read from the circuit in the same order as they were written to the circuit. As a storage device, the FIFO is also sometimes referred to as a FIFO memory and sometimes is referred to as a FIFO random access memory ("RAM"). Typically, a FIFO is a logical array for storing a number of data words. Data word size of the FIFO depends on the application and may be any number of bits, where 4 bits, 8 bits, 16 bits, and 32 bits are common examples, while any number of bits per word may be implemented based on the application. The number of words in a given FIFO also is typically dictated at least in part by the application.

Given the prevalence of FIFO storage circuits, and as is the case with various other circuits as well, a need has arisen to test the FIFO storage circuit once constructed in an integrated circuit. Typically such testing is performed by a manufacturer before the device that includes the FIFO storage circuit is sold, where testing of the FIFO storage circuit determines whether the circuit operates to properly store data of all possible states in each of its memory locations. If an error in operability is found, in some instances provisions are made to correct a certain amount of such errors so that the device is still a saleable product. For example, certain types of redundancy or the like may be implemented so that detected errors may be corrected. In any event, with such testing, better end-product reliability is improved as is ultimate manufacturer yield.

Many FIFO RAMs are presently implemented in one of two manners. A first manner of implementing a FIFO RAM is sometimes referred to as a layout RAM. In the layout RAM, an optimized transistor layout structure is used to provide data storage. The layout RAM FIFO is often tested using a conventional built-in self-test ("BIST") technique. In this case, the extra area consumed on the integrated circuit to support the BIST is relatively small compared to the actual memory structure. A second manner of implementing a FIFO RAM is sometimes referred to as a synthesizable RAM. Synthesizable RAMs are often used for smaller memory configurations where it is undesirable to use a BIST structure for reasons such as available area on the integrated circuit. In the synthesizable RAM, common logic elements are used for each storage cell. The usual logic element is a flip flop, which is required to support the testability of the circuit and where that testability is achieved using a so-called scan chain, as further discussed below. Prior to that discussion, it is noted that the preferred embodiments are directed to such RAMs that heretofore have used scan chain technology.

As introduced above, one common known manner of testing a FIFO storage circuit involves using a scan chain. The scan chain is built into the FIFO structure, where the scan chain is then available for testing but also can be rendered transparent for purposes of normal operational use of the FIFO structure as a memory device. In the prior art, the scan chain is constructed by connecting each individual storage cell in the FIFO to another cell in the FIFO, so that a data transferring chain is created between all cells. Thus, in a FIFO with M words, each having N cells, then the FIFO includes a total number of MxN cells and the scan chain consists of the same number of MxN cells. In a logical sense, typically the chain is such that along one word of storage, each cell, other than the final cell in the word, has an output connected as an input to a successive cell, and the final cell in the word has an output connected as an input to the first cell in a next successive word. In order to implement the scan chain while also providing a structure that will also operate under normal operations as a FIFO structure, typically each response to a transition in a clock signal to the flip flop. Further, each cell includes some level of multiplexing so that during testing data from each cell may be routed along the scan chain, whereas after testing and during normal operation each cell may be written and read according to the typical manner of doing so with a FIFO structure, typically in response to a read and write pointer. In any event, with the presence of the scan chain, a known test sequence of bits is scanned into the chain, that is, into the FIFO structure, and it is then scanned out of the chain. In this manner, the scanned out data may be examined to ensure that it is what is to be expected given the known input test sequence, and any deviations in what is expected in the output provides a basis to conclude that the cell corresponding to the located deviation is not properly functioning.

While the above-described approach has proven workable in various implementations, the present inventor has observed that the prior art may include various drawbacks. For example, the use of flip flops in the synthesizable FIFO RAM necessarily brings with it the complexity of those devices and consumes a considerable amount of area on the integrated circuit. As another example, overall cost of the device is correspondingly increased. As a final example, the MxN scan chain may have an impact on the performance of the device. Thus, the preferred embodiments as set forth below seek to improve upon the prior art as well as these associated drawbacks.

US patent number 6,061,813 describes memory testing apparatus capable of testing both memories of a parallel input/parallel output type and a serial input/serial output type. In the case of testing the serial input/serial output type memory, failure data in read out data serially outputted from the memory are separated in bit by bit basis and are stored in a failure analysis memory at different time points in the time axis so that a failure bit position can be specified.

### BRIEF SUMMARY OF THE INVENTION

The preferred embodiment is an electronic device according to claim 1. The device comprises a first-in first-out memory structure, which comprises an integer M of memory word slots. Each memory word slot is operable to store an integer N of bits. The device also comprises a scan storage circuit, operable to receive a scan word having a number of bits less than MxN, and read and write pointers. The device also comprises control circuitry for scan testing of said electronic device operable to: set the read and write pointers to indicate a desired memory word slot of the memory structure, read a word from the indicated memory word slot of the memory structure into the scan storage circuit, load a scan word into the scan storage circuit during a same period as shifting out the prior word from the scan storage circuit, write the scan word from the scan storage circuit into the indicated memory word slot of the memory structure, determine whether all scan words have been written into and read from the memory structure, and advance the read and write pointers to a next memory word slot in the memory structure, if not all scan words have been processed

Other aspects are also disclosed and claimed.

### BRIEF DESCRIPTION OF THE SEVERAL VIEWS OF THE DRAWING

Figure 1 illustrates a block diagram of a data storage system according to the preferred embodiments.
Figure 2 illustrates a flow chart of the operation of the data storage system of Figure 1 for purposes of testing the operability of each storage cell in the FIFO of that system.

### DETAILED DESCRIPTION OF THE INVENTION

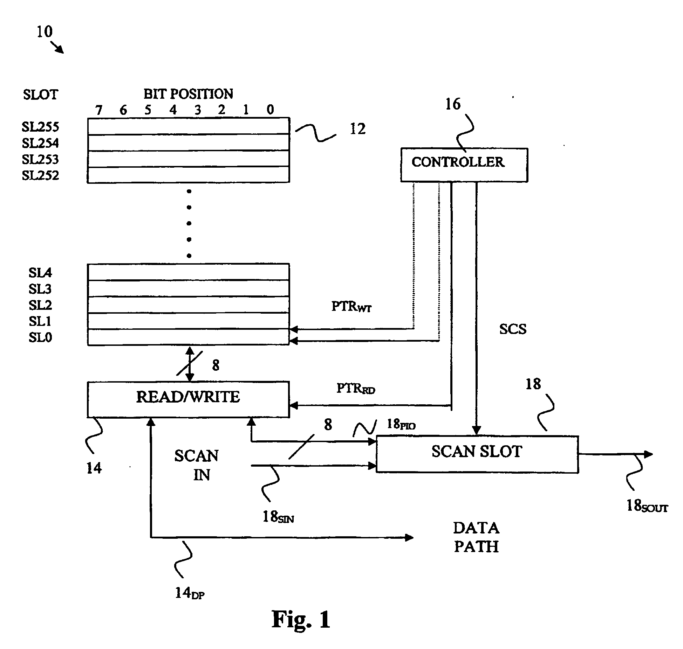

Figure 1 illustrates a block diagram of a data storage system designated generally at 10 according to the preferred embodiments. In one preferred embodiment, system 10 is constructed using a single integrated circuit and, indeed, additional circuitry is likely included within such an integrated circuit. Indeed, some of this additional circuitry may utilize the data stored in system 10. However, to simplify the present illustration and discussion, such additional circuitry is neither shown nor described. Moreover, system 10 may be implemented in connection with numerous digital data systems, where one skilled in the art may ascertain such systems.

Looking to the blocks in system 10, system 10 includes various items which in general are known in the prior art, but an additional scan feature as well as related control and operation distinguishes the overall system as detailed later. Looking by way of introduction to some of the blocks that are comparable to the prior art, they include a first-in first-out ("FIFO") memory 12 having a number M of word storage slots; by way of example, 256 such slots are shown and designated SL0 through SL255. However, the choice of 256 is only by way of illustration and one skilled in the art will recognize that the inventive teachings of this document may be implemented in different sized FIFO devices. In the preferred embodiment, each storage slot SLx has a same N-bit dimension, where that dimension may be any size. For the sake of example in this document, assume that this dimension is 8 bits, that is, each storage slot is operable to store an 8-bit word in eight respective data cells. Accordingly, in Figure 1, the eight bit positions are indicated as bit positions 0 through 7. Also included in system 10 are a write pointer PTR_{WT} and a read pointer PTR_{RD}. In general, write pointer PTR_{WT} indicates the word slot into which a next word will be written into FIFO memory 12. Conversely, read pointer PTR_{RD} indicates the word slot from which a next word will be read from FIFO memory 12. The implementation of, and indication by , the respective word pointers PTR_{WT} and PTR_{RD} may be achieved in various fashions ascertainable by one skilled in the art and consistent with the functionality described in this document. System 10 also includes a data read/write circuit 14 connected to FIFO memory 12 in a manner that allows a word to be written into, or read from, FIFO memory 12 in a given cycle, according to the indication of the relevant one of write pointer PTR_{WT} and read pointer PTR_{RD}. In one mode, read/write circuit 14 is operable to communicate date with respect to the system data path, and for testing it may communicate elsewhere as further detailed below. Also, data read/write circuit 14 may be constructed in various manners, such as to include multiplexing circuitry or the like.

Turning now to aspects of system 10 as part of the overall inventive structure, system 10 includes a controller 16 coupled to control both write pointer PTR_{WT} and read pointer PTR_{RD}. In one sense, controller 16 communicates with these two pointers to increment each pointer as normal individual read and write operations occur with respect to single respective storage slots as known in the art. However, and as detailed later, controller 16 also operates in connection with these pointers to read and write scan data in an inventive manner for purposes of testing FIFO memory 12. Further in this regard, controller 16 also provides a scan control signal SCS to a scan slot 18. In the preferred embodiment, scan slot 18 is a storage circuit sized to store a word of data having a same size as the word size of FIFO memory 12; thus, in the present example where each word slot SL*x* in FIFO memory 12 stores eight bits, then scan slot 18 is an 8-bit storage circuit. Scan slot 18 has a scan in data input 18_{SIN} and a scan out data output 18sowr, where the former is for inputting an 8-bit scan data word into scan slot 18, and the latter is for outputting an 8-bit test word from scan slot 18, meaning a word of scan data after it has been tested in a storage slot of FIFO memory 12. Scan slot 18 also is bi-directionally connected to read/write circuit 14 for purposes of reading test data from, and writing test data to, FIFO memory 12 as further discussed later. Also, consistent with other scan methodologies, in the preferred embodiment, scan slot 18 is a serial shift device. Thus, an input scan data word is serially shifted into scan slot 18 via input 18_{SIN} and, thus, in the present example, eight clock cycles are required to shift in eight bits, while during those eight cycles the eight bits that were stored in scan slot 18 are shifted out, one bit per cycle, via output 18_{SOUT}. Also, in an alternative embodiment, scan slot 18 may be written and read in parallel, although preferably the serial approach is used because it has the benefit to scan using a single input/output pair to shift large amount of data, where this advantage does not exist in parallel read/writing due to the need of having parallel access, meaning a full parallel bus having the width of scan slot 18. In any event, and in regard to its scan testability, scan slot 18 is also bi-directionally connected to data read/write circuit 14, for reasons more clear below. Lastly, from the remaining functional description of controller 16 and scan slot 18, note that both of these may be constructed in various fashions ascertainable by one skilled in the art. Thus, each cell in scan slot 18 may be constructed using a flip flop and with sufficient multiplexing circuitry so as to support serial shifting of data through scan slot 18 as well as parallel writing of data from, and parallel reading of data to, scan slot 18 relative to read/write circuit 14. Note that the parallel transfer of data between read/write circuit 14 and scan slot 18 is achieved in the latter by way of a parallel input/output 18_{PIO}.

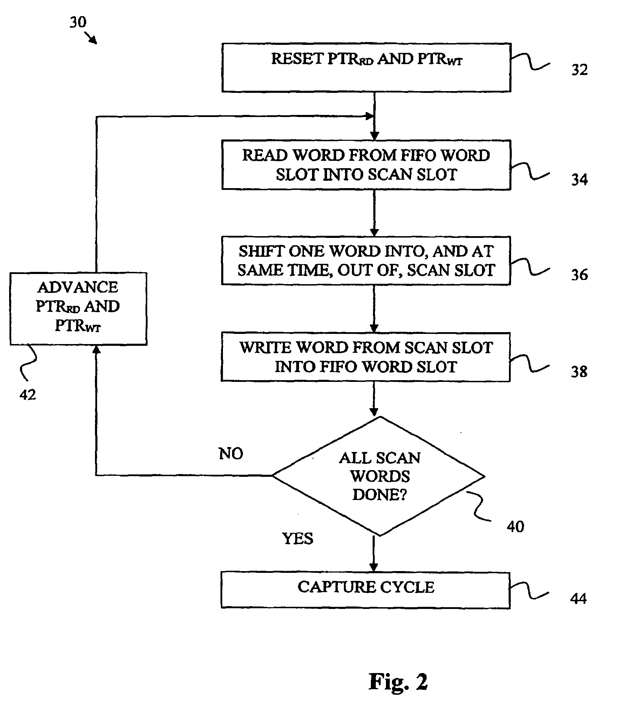

Figure 2 illustrates a flow chart of a method of operation of system 10 of Figure 1, designated generally at 30 and performed to test the data storage accuracy of FIFO memory 12. By way of introduction, method 30 is accomplished under the control of controller 16, as may be implemented using various techniques known to one skilled in the art. Further, controller 16 performs method 30 with respect to the remaining circuitry of system 10 so as to test the data storage capability of each cell (i.e., bit) in each word storage slot of FIFO memory 12. Such testing will be further appreciated from the remaining discussion.

Method 30 starts with a step 32, which resets read pointer PTR_{RD} and write pointer PTRwr to point to a same location in FIFO memory 12. By way of example, assume that both read pointer PTR_{RD} and write pointer PTRwr are cleared to point to word storage slot SL0. Thus, a next read will be from storage slot SL0, and a next write will be to storage slot SL0. Next, method 30 continues from step 32 to step 34.

In step 34, a word is read from the storage slot then-indicated by read pointer PTR_{RD}. By way of example, assume that step 34 has been reached directly from step 32, where recall that read pointer PTR_{RD} was cleared to point to slot SL0. Thus, in this occurrence of step 34, the word at slot SL0 is read. Also in connection with step 34, the read word is read, via read/write circuit 14, into scan slot 18. Next, method 30 continues from step 34 to step 36.

In step 36, scan slot 18 is shifted one word length, and for sake of convention the shift is to the right according to the orientation depicted in Figure 1. Recalling that scan slot 18 is preferably a serial register, and for the above-introduced example of an 8-bit word, then scan slot 18 is shifted eight bit times. Further, during a same time period, one scan word is scanned into scan slot 18 via input 18_{SIN,} while at the same time one tested word is scanned out of scan slot 18 via output 18_{SOUT}. Continuing the preceding example, therefore, recall that the word from slot SL0 in FIFO memory 12 was read into scan slot 18 in the immediately-preceding step 34. As a result, in step 36 that word is scanned out of scan slot 18. The scanned-out word is made available to a capture circuit or the like so as to be examined for testing purposes, as further appreciated below. Next, method 30 continues from step 36 to step 38.

In step 38, a word is written from input/output 18_{PIO} of scan slot 18, via read/write circuit 14 and preferably in parallel, into the storage slot then-indicated by write pointer PTR_{WT}. By way of example, assume that step 34 has been reached in the first iteration of method 30, where as discussed later it will be seen that step 34 is reached repeated times for writing to different word storage slots in FIFO memory 12. Thus, keeping with this example, assume that step 38 is reached when write pointer PTR_{WT} was cleared to point to slot SL0. As a result, in this instance of step 38, a word is written into slot SL0. Next, method 30 continues from step 38 to step 40.

In step 40, method 30 determines whether all scan words have been written into, and read from, FIFO memory 12. In other words, some determined number of scan words will be known as to be used for testing FIFO memory 12, and step 40 will therefore determine whether each of these words has been input and output with respect to FIFO memory 12 for testing. In a contemporary application, the number of total tested words may vary based on various considerations. In an ideal case, only a single write/read cycle would be needed to test the correct behavior of a given word; however, due to aliasing and other effects, there is a need for much more cycles to exhaustively test memory 12 array with various sequences. These sequences are know as "march patterns" and they consist in writing/reading various values in words at various locations with a defined order. A common way to name those algorithms is by the number of cycles it requires per word, say "*LM*". For example, a "13*M*" algorithm requires a given word to be accessed 13 times and thus the complete memory will require 13M accesses to be fully tested. There are actually several embedded cycle loops involved in testing the full memory structure, including: (1) the *N* loop to input/output one scan slot18; (2) the *M* loop repeating M times the *N* loop to shift in/out the complete arrays contents one time; and (3) the *L* loop repeating *L* times the *M* loop to insure the array is exhaustively tested as per the "LM" algorithm. Thus, the total number of clock cycles to test the FIFO would thus be roughly *L***M***N* and the number of total tested words may be on the order of *L***M,* where typical values for *L* is 8 to 16. In any event, if step 40 determines that not all test words have been so processed, then method 30 continues from step 40 to step 42, where both read pointer PTR_{RD} and write pointer PTR_{WT} are advanced. Thus, in the current example, where prior to reaching step 42 those pointers both point to slot SL0, then in the first instance of step 42 each of those pointers advances to slot SL1. Note also that in a later instance of step 42 and once the pointers are pointing to the logical top of FIFO memory 12 (i.e., slot SL255), then the step 42 advancement of those pointers causes them to wrap around to the logical bottom of FIFO memory 12 such that they again then point to slot SL0. Returning to step 40, if it determines that all test words have been input and output, then method 30 continues from step 40 to step 44. Step 44 is a capture cycle, which is used in the same general sense as the prior art, namely, the sequence of test data words that has been read from FIFO memory 12 is analyzed to determine whether it departs in any way from that which is expected. Any such departure leads to an investigation and identification of the location in FIFO memory 12 that produced the erroneous data, thereby indicating a possible faulty storage element(s) in FIFO memory 12. If a fault is detected, corrective action may then be taken if possible or the problematic device may be separated from usable inventory.

Having described each step in method 30, an example of the overall operation is now instructive in further appreciating that method as well as some benefits of the preferred embodiments over the prior art. In this example, assume that a sequence of 512 words are to be tested through FIFO memory 12, that is, those words are to be written into and read from FIFO memory 12, with the results then being available for capture so as to examine whether the bits of those test words represent the expected binary states. Looking to method 30, when step 32 first occurs, note at this point that the information in FIFO memory 12 will represent some reset-type state, that is, each bit may reset to some expected or unexpected state, and for purposes of this discussion may be considered to be invalid or irrelevant data. By way of introduction and as shown below, thereafter for a first 256 cycles, a first set of 256 of the 512 test words in the test sequence are written into FIFO memory 12, while the data therein prior to those writes is not particularly meaningful. Thereafter, however, the first set of 256 words is read out, one word at a time, while interspersed with each read is the writing of one of the words from the second set of 256 of the total of 512 words in the test sequence. Thereafter, the second set of 256 words are also read out of FIFO memory 12, followed by a capture cycle during which all 512 tested words may be analyzed. These various operations are further detailed, below.

Continuing with the example of the preceding paragraph in more detail, wherein 512 total test words are to be written to and read from FIFO memory 12, first in step 32 both pointers PTR_{RD} and PTR_{WT} indicate slot SL0. Next, step 34 reads the word, from slot SL0 as indicated by read pointer PTR_{RD}, in parallel into scan slot 18 via its input 18_{PIO}. Note however, and as introduced above, at this point the data that is read by the first occurrence of step 34, from slot SL0, is not valid test data as it does not reflect data that was previously stored in FIFO memory 12 as part of the test operation. Next, step 36 shifts scan slot 18 logically right by one word, thereby shifting out the word read from the immediately-preceding step 34 and also shifting in, via input 18_{SIN}, the first test word in the first set of 256 of the total 512 words. Next, step 38 writes the first test word, now located in scan slot 18, from parallel input/output 18_{PIO} to slot SL0 of FIFO memory 12, which is indicated by write pointer PTR_{WT}. Next, step 40 determines whether all test words have been written into and read from FIFO memory 12; in the present example, this requires 512 writes and reads of these test words, which at this point in the example are not complete. Thus, method 30 continues to step 42 which advances both pointers, thereby causing them to indicate slot SL1 in the present example. Thereafter, method 30 continues as further discussed below.

Continuing with the preceding example and now having written one valid test word into slot SL0 of FIFO memory 12, step 34 reads another word, which in this instance of step 34 is from slot SL1, as indicated by read pointer PTR_{RD}; again the word is read in parallel via input/output 18_{PIO} into scan slot 18. However, and as introduced above, at this point the data that is read by this second occurrence of step 34, from slot SL1, is not valid test data as it also does not reflect data that was previously stored in FIFO memory 12 as part of the test operation. Thus, at this point, one skilled in the art should appreciate that for the first 256 instances of step 34, 256 successive words will be read, respectively from slots SL0 through SL255, out of FIFO memory 12; however, each of these words is not valid test data as each does not reflect data that was previously stored in FIFO memory 12 as part of the test operation. However, for each such occurrence of step 34, immediately following it will be an occurrence of step 36, where a valid test word is shifted into scan slot 18 via input 18_{SIN}, and that is immediately followed by an occurrence of step 38, where a valid test word is written from input/output 18_{PIO} of scan slot 18 into a word slot in FIFO memory 12.

Continuing still further with the above-described example, assume now that 256 occurrences of steps 34, 36, and 38 have occurred for the example that includes a total of 512 test words. At this point in the example, therefore, 256 valid test words have been written into FIFO memory 12, while 256 words have been read from FIFO memory 12, although those words may not bear on the testing operation since they do not represent test words written into FIFO memory 12 (unless the test is for sake of verifying other expected data in FIFO memory 12, such as an anticipated value at start-up or reset). Following the 256^{th} occurrence of step 38 in this example, step 40 determines that not all scan words have been written to and read from FIFO memory 12 because there still remains 256 of the 512 test words that have not been written to or read from FIFO memory 12. Thus, control continues to step 42, which advances both pointers. Note that due to the preceding 256 advancements of those pointers, prior to the present occurrence of step 42, both pointers indicate slot SL255; however, this occurrence (i.e., the 257^{th}) of step 42 causes the pointers to wrap around to now indicate slot SL0. Next, the 257^{th} occurrence of step 34 occurs. In this step, the first actual test word, written 256 occurrences of step 38 earlier into slot SL0, is now read from slot SL0 into input/output 18_{PIO} of scan slot 18. Next, the 257^{th} occurrence of step 36 occurs. In this step, the first test word, now in scan slot 18, is shifted out of output 18_{OUT} of scan slot 18, and at the same time and for each bit shift, the 257^{th} test word is shifted into input 18_{SIN} of scan slot 18. Next, the 257^{th} occurrence of step 38 occurs. In this step, the 257^{th} test word, now in scan slot 18, is written in parallel and via input/output 18_{PIO} into slot SL0 of FIFO memory 12. Next, step 40 occurs, and because not all 512 test words have been written into, and read from, FIFO memory 12, once again step 42 increments read and write pointers PTR_{RD} and PTR_{WT}. Given the preceding, one skilled in the art will appreciate that numerous additional occurrences of steps 34, 36, and 38 will occur, and indeed, after the 512^{th} occurrence of step 38, all test words, over the various iterations, will have been written into FIFO memory 12. However, on the 512^{th} occurrence of step 40, 256 of the test words still remain in FIFO memory 12; accordingly, control will continue again to step 42, and the sequence will continue for another 256 occurrences of step 34 (and steps 36 and 38), where after those 256 occurrences of step 34, the last 256 of the total of 512 test words will have been read from FIFO memory 12, word by word, in parallel into scan slot 18. Moreover, each instance of step 36, immediately following a respective one of these instances of step 34, will shift the read test word out of output 18scour of scan slot 18, while at the same time shifting in a word via input 18_{SIN}, but that word may be considered unimportant because it follows the already-written sequence of 512 test words. Finally, therefore, in the 768^{th} occurrence of step 40, it will conclude that all 512 test words have been written into FIFO memory 12 (in the first 512 of 768 occurrences of step 38), and all 512 test words have been read out of FIFO memory 12 (in the last 512 of 768 occurrences of step 34). Thus, at this point control continues from step 40 to step 44, during which the sequence of 512 test words may be captured and then analyzed by techniques known to or ascertainable by one skilled in the art. Note also that when method 30 is not occurring, normal operations of FIFO memory 12 may occur by disabling the path between scan slot 18 and read/write circuit 14, thereby permitting data communications between FIFO memory 12 and the normal operational data path of system 10, as shown via conductor 14_{DP}.

From the above, it may be appreciated that the above embodiments provide a scan testable first-in first-out ("FIFO") memory circuit, as may be implemented in various devices, and with various benefits. The preferred embodiments substantially reduce the number of scan chain elements needed for testing the FIFO circuit, where recall that the prior art includes MxN such elements for an array of M words with N bits each; in contrast, in the preferred embodiment considerably less scan chain elements are implemented, where preferably the reduced number is only N scan chain bits. As another benefit, since the scan chain of the preferred embodiment is in a storage slot that is separate from the actual FIFO memory, then in the preferred embodiment the FIFO memory cells may be constructed using less complex circuitry as compared to the prior art. For example, as mentioned above, in prior art synthesizable FIFO memories, often a flip-flop is required along with sufficient multiplexing circuitry for each cell in the memory so as to support the scan testability. In contrast, in the preferred embodiment each FIFO memory cell does not require a clocked cell (e.g., a flip flop) and, hence, a simpler circuit such as a latch may be used for each such cell. Such a latch may be input of the first inverter. With less complex cell structures in the preferred embodiment, a much smaller system is provided, thereby having a positive impact on product size, power consumption, and cost. Note also that the preferred embodiments may be applied to FIFOs with various different number of storage slots and word sizes per slot. Thus, these examples provide yet other bases from which one skilled in the art may ascertain yet other benefits and variations, and indeed while the present embodiments have been described in detail, various substitutions, modifications or alterations could be made to the descriptions set forth above without departing from the scope of the invention as defined by the appended claims.

## Claims

1. An electronic device (10), comprising:
a first-in first-out memory structure (12) comprising an integer *M* of memory word slots (SL0...SL255), wherein each memory word slot is operable to store an integer *N* of bits;
a scan storage circuit (18), operable to receive a scan word having a number of bits less than MxN; **characterized by**
read and write pointers (PTR_{RD}, PTR_{WT}); and
control circuitry (16) for scan testing of said electronic device (10) operable to
set read and write pointers (PTR_{RD}, PTR_{WT}) to indicate a desired memory word slot of the memory structure (12),
read a word from the indicated memory word slot of the memory structure (12) into the scan storage circuit (18),
load a scan word into the scan storage circuit (18) during a same period as shifting out the prior word from the scan storage circuit,
write the scan word from the scan storage circuit (18) into the indicated memory word slot of the memory structure (12),
determine whether all scan words have been written into and read from the memory structure (12), and
advance the read and write pointers (PTR_{RD}, PTR_{WT}) to a next memory word slot in the memory structure (12), if not all scan words have been processed.

2. The electronic device of claim 1 wherein the scan storage circuit (18) is operable to receive a scan word consisting of *N* bits.

3. The electronic device of claim 1 or 2 wherein the scan storage circuit (18) comprises a serial shift storage circuit for serially causing each successive scan word to be read from the scan storage circuit during a same time period as a corresponding successive scan word is written into the scan storage circuit.

4. The electronic device of any one of claims 1 to 3 wherein the scan storage circuit (18) further comprises circuitry (18_{PIO}) for causing each successive scan word to be written from the scan storage circuit into the memory structure (12) in parallel, and for causing each successive scan word to be read from the memory structure into the scan storage circuit in parallel.

5. The electronic device of claim 4:
wherein the successive scan words to be written into the scan storage circuit (18) comprise a test sequence; and
further comprising circuitry for comparing the successive scan words to be read from the memory structure to the test sequence.

6. The electronic device of claim 5:
wherein each of a plurality of memory word slots is operable to store the integer N of bits in a corresponding set of *N* memory cells; and
wherein each set of *N* memory cells comprises N latches.

7. A method (30) of scan testing an electronic device (10), the device comprising a first-in first-out memory structure (12) comprising an integer M of memory word slots (SL0...SL255), wherein each memory word slot is operable to store an integer N of bits, a scan storage circuit (18) operable to receive a scan word having a number of bits less than MxN, read and write pointers (PTR_{RD},PTR_{WT}), and control circuitry (16),
said method comprising the steps of:
a) setting (32) read and write pointers to indicate a desired memory word slot of the memory structure;
b) reading (34) a word from the indicated memory word slot of the memory structure into the scan storage circuit
c) loading (36) a scan word into the scan storage circuit during a same period as shifting out the prior word form the scan storage circuit,
d) writing (38) the scan word from the scan storage circuit into the indicated memory word slot of the memory structure,
e) determining (40) whether all scan words have been written into and read from the memory structure, and
f) if not all scan words have been processed, advancing (42) the read and write pointers to a next memory word slot in the memory structure; and
g) repeating steps b) to f) until all scan words have been written into and read from the memory structure.

8. The method of claim 7 wherein the scan storage circuit (18) is operable to receive a scan word consisting of *N* bits.

## Patentansprüche

1. Elektronische Vorrichtung (10), mit:
einer First-in/First-out-Speicherstruktur (12), die eine ganze Zahl M von Speicherwortschlitzen (SL0 ... SL255) enthält, wovon jeder betreibbar ist, um eine ganze Zahl N von Bits zu speichern;
einer Abtastspeicherschaltung (18), die betreibbar ist, um ein Abtastwort zu empfangen, das eine Anzahl von Bits, die kleiner als M × N ist, besitzt;
**gekennzeichnet durch**
Lese- und Schreibzeiger (PTR_{RD}, PTR_{WT}); und
eine Steuerschaltungsanordnung (16) zum Abtast-Testen der elektronischen Vorrichtung (10), die betreibbar ist, um
Lese- und Schreibzeiger (PTR_{RD}, PTR_{WT}) zu setzen, um einen gewünschten Speicherwortschlitz der Speicherstruktur (12) anzugeben,
ein Wort aus dem angegebenen Speicherwortschlitz der Speicherstruktur (12) in die Abtastspeicherschaltung (18) zu lesen,
ein Abtastwort während derselben Periode, in der das vorhergehende Wort aus der Abtastspeicherschaltung geschoben wird, in die Abtastspeicherschaltung (18) zu laden,
das Abtastwort aus der Abtastspeicherschaltung (18) in den angegebenen Speicherwortschlitz der Speicherstruktur (12) zu schreiben,
zu bestimmen, ob alle Abtastwörter in die Speicherstruktur (12) geschrieben und aus der Speicherstruktur (12) gelesen worden sind, und
die Lese- und Schreibzeiger (PTR_{RD}, PTR_{WT}) in den nächsten Speicherwortschlitz in der Speicherstruktur (12) weiterzuleiten, falls nicht alle Abtastwörter verarbeitet worden sind.

2. Elektronische Vorrichtung nach Anspruch 1, wobei die Abtastspeicherschaltung (18) betreibbar ist, um ein aus N Bits bestehendes Abtastwort zu empfangen.

3. Elektronische Vorrichtung nach Anspruch 1 oder 2, wobei die Abtastspeicherschaltung (18) eine Reihenverschiebungs-Speicherschaltung umfasst, um der Reihe nach zu veranlassen, dass jedes aufeinander folgende Abtastwort in derselben Periode, in der ein entsprechendes aufeinander folgendes Abtastwort in die Abtastspeicherschaltung geschrieben wird, aus der Abtastspeicherschaltung gelesen wird.

4. Elektronische Vorrichtung nach einem der Ansprüche 1 bis 3, wobei die Abtastspeicherschaltung (18) ferner eine Schaltungsanordnung (18_{PIO}) enthält, um zu bewirken, dass jedes aufeinander folgende Abtastwort von der Abtastspeicherschaltung parallel in die Speicherstruktur (12) geschrieben wird, und um zu bewirken, dass jedes aufeinander folgende Abtastwort aus der Speicherstruktur parallel in die Abtastspeicherschaltung gelesen wird.

5. Elektronische Vorrichtung nach Anspruch 4:
wobei die aufeinander folgenden Abtastwörter, die in die Abtastspeicherschaltung (18) geschrieben werden sollen, eine Testfolge enthalten; und
ferner mit einer Schaltungsanordnung zum Vergleichen der aufeinander folgenden Abtastwörter, die aus der Speicherstruktur gelesen werden sollen, mit der Testfolge.

6. Elektronische Vorrichtung nach Anspruch 5,
wobei jeder der mehreren Speicherwortschlitze betreibbar ist, um die ganze Zahl N von Bits in einer entsprechenden Menge von N Speicherzellen zu speichern; und
wobei jede Menge von N Speicherzellen N Signalspeicher enthält.

7. Verfahren (30) zum Abtast-Testen einer elektronischen Vorrichtung (10), wobei die Vorrichtung versehen ist mit einer First-in/First-out-Speicherstruktur (12), die eine ganze Zahl M von Speicherwortschlitzen (SL0 ... SL255) enthält, wobei jeder Speicherwortschlitz betreibbar ist, um eine ganze Zahl N von Bits zu speichern, einer Abtastspeicherschaltung (18), die betreibbar ist, um ein Abtastwort zu empfangen, das eine Anzahl von Bits, die kleiner als M × N ist, besitzt, Lese- und Schreibzeigern (PTR_{RD}, PTR_{WT}) und einer Steuerschaltungsanordnung (16),
wobei das Verfahren die folgenden Schritte umfasst:
a) Setzen (32) von Lese- und Schreibzeigern, um einen gewünschten Speicherwortschlitz der Speicherstruktur anzugeben;
b) Lesen (34) eines Wortes aus dem angegebenen Speicherwortschlitz der Speicherstruktur in die Abtastspeicherschaltung,
c) Laden (36) eines Abtastwortes in die Abtastspeicherschaltung in derselben Periode, in der das frühere Wort aus der Abtastspeicherschaltung geschoben wird,
d) Schreiben (38) des Abtastwortes aus der Abtastspeicherschaltung in den angegebenen Speicherwortschlitz der Speicherstruktur,
e) Bestimmen (40), ob alle Abtastwörter in die Speicherstruktur geschrieben und aus der Speicherstruktur gelesen worden sind, und
f) dann, wenn nicht alle Abtastwörter verarbeitet worden sind, Weiterstellen (42) der Lese- und Schreibzeiger auf einen nächsten Speicherwortschlitz in der Speicherstruktur; und
g) Wiederholen der Schritte b) bis f), bis alle Abtastwörter in die Speicherstruktur geschrieben und aus der Speicherstruktur gelesen worden sind.

8. Verfahren nach Anspruch 7, wobei die Abtastspeicherschaltung (18) betreibbar ist, um ein Abtastwort zu empfangen, das aus N Bits besteht.

## Revendications

1. Dispositif électronique (10) comprenant :
une structure de mémoire premier entré, premier sorti (12) comprenant un nombre entier M de créneaux de mot de mémoire (SL0... SL255), dans lequel chaque créneau de mot de mémoire est activable pour stocker un nombre entier N de bits;
un circuit de stockage de balayage (18), activable pour recevoir un mot de balayage ayant un nombre de bits inférieur à M x N, **caractérisé par**
des pointeurs de lecture et d'écriture (PTR_{RD} et PTR_{WT}) et
des circuits de commande (16) pour un essai par balayage dudit dispositif électronique (10) activables pour :
positionner les pointeurs de lecture et d'écriture (PTR_{RD} et PTR_{WT}) afin d'indiquer un créneau de mot de mémoire souhaitée de la structure de mémoire (12),
extraire un mot du créneau de mot de mémoire indiqué de la structure de mémoire (12) dans le circuit de stockage de balayage (18),
charger un mot de balayage dans le circuit de stockage de balayage (18) durant une même période que le décalage vers l'extérieur du mot précédent du circuit de stockage de balayage,
introduire le mot de balayage du circuit de stockage de balayage (18) dans le créneau de mot de mémoire indiqué de la structure de mémoire (12),
déterminer si tous les mots de balayage ont été introduits dans et extraits de la structure de mémoire (12), et
avancer les pointeurs de lecture et d'écriture (PTR_{RD} et PTR_{WT}) vers un nouveau créneau de mot de mémoire dans la structure de mémoire (12), si tous les mots de balayage n'ont pas été traités.

2. Dispositif électronique selon la revendication 1, dans lequel le circuit de stockage de balayage (18) est activable pour recevoir un mot de balayage se composant de N bits.

3. Dispositif électronique selon la revendication 1 ou 2, dans lequel le circuit de stockage de balayage (18) comprend un circuit de stockage à décalage en série pour permettre à chaque mot de balayage successif d'être extrait en série du circuit de stockage de balayage durant une même période de temps durant laquelle un mot de balayage successif correspondant est introduit dans le circuit de stockage de balayage.

4. Dispositif électronique selon l'une quelconque des revendications 1 à 3, dans lequel le circuit de stockage de balayage (18) comprend en outre des circuits (18_{PIO}) pour permettre à chaque mot de balayage successif d'être introduit à partir du circuit de stockage de balayage dans la structure de mémoire (12) en parallèle, et pour permettre à chaque mot de balayage successif d'être extrait de la structure de mémoire dans le circuit de stockage de balayage en parallèle.

5. Dispositif électronique selon la revendication 4, dans lequel les mots de balayage successifs à introduire dans le circuit de stockage de balayage (18) comprennent une séquence d'essai ; et
comprenant en outre des circuits pour comparer les mots de balayage successifs à extraire de la structure de mémoire à la séquence d'essai.

6. Dispositif électronique selon la revendication 5,
dans lequel chacun d'une pluralité de créneaux de mot de mémoire est activable pour stocker le nombre entier N de bits dans un ensemble correspondant de N cellules de mémoire; et
dans lequel chaque ensemble de N cellules de mémoire comprend N bascules.

7. Procédé (30) d'essai par balayage d'un dispositif électronique (10), le dispositif électronique (10) comprenant :
une structure de mémoire premier entré, premier sorti (12) comprenant un nombre entier M de créneaux de mot de mémoire (SL0... SL255), dans lequel chaque créneau de mot de mémoire est activable pour stocker un nombre entier N de bits, un circuit de stockage de balayage (18), activable pour recevoir un mot de balayage ayant un nombre de bits inférieur à M x N, des pointeurs de lecture et d'écriture (PTR_{RD} et PTR_{WT}) et des circuits de commande (16),
ledit procédé comprenant les étapes consistant à :
(a) positionner (32) les pointeurs de lecture et d'écriture (PTR_{RD} et PTR_{WT}) afin d'indiquer un créneau de mot de mémoire souhaité de la structure de mémoire,
(b) extraire (34) un mot du créneau de mot de mémoire indiqué de la structure de mémoire dans le circuit de stockage de balayage,
(c) charger (36) un mot de balayage dans le circuit de stockage de balayage durant une même période que le décalage vers l'extérieur du mot précédent du circuit de stockage de balayage,
(d) introduire (38) le mot de balayage du circuit de stockage de balayage dans le créneau de mot de mémoire indiqué de la structure de mémoire,
(e) déterminer (40) si tous les mots de balayage ont été introduits dans et extraits de la structure de mémoire, et
(f) si tous les mots de balayage n'ont pas été traités, avancer (40) les pointeurs de lecture et d'écriture (PTR_{RD} et PTR_{WT}) vers un nouveau créneau de mot de mémoire dans la structure de mémoire (12),
(g) répéter les étapes b) à f) jusqu'à ce que tous les mots de balayage aient été introduits dans et extraits de la structure de mémoire.

8. Procédé selon la revendication 7, dans lequel le circuit de stockage de balayage (18) est activable pour accueillir un mot de balayage se composant de N bits.
